# FASCICULE DE BREVET EUROPEEN

(11) **EP 0 762 821 B1**
(45) Date de publication et mention de la délivrance du brevet: **17.02.1999**
(21) Numéro de dépôt: 96401827.9
(22) Date de dépôt: 27.08.1996
(51) Int. Cl.: H05K 7/20, H01F 27/14

(54) **Dispositif de filtrage d'un milieu liquide isolant électrique et caloriporteur et groupe d'électronique de puissance comportant un tel dispositif**
Vorrichtung zum Filtern eines elektrisch isolierenden und wärmeleitenden Flüssigkeitsmediums und damit ausgerüstete Leistungselektronikbaugruppe
Filtering device for electrically insulated and heat conductive liquid medium and power electronic assembly provided with the same

(30) Priorité: 30.08.1995 FR 9510218
(43) Date de publication de la demande: 12.03.1997
(73) Titulaire: GEC ALSTHOM TRANSPORT SA, 75016 Paris (FR)
(72) Inventeur: Jacquelin, Jean, 91470 Forges les Bains (FR); Agnoux, Claude, 91340 Ollainville (FR)
(74) Mandataire: Gosse, Michel

(56) Documents cités:
- DE-A- 2 257 615
- FR-A- 1 064 730
- IEEE TRANSACTIONS ON INDUSTRY APPLICATIONS, vol. 26, no. 3, 1 Mai 1990, pages 394-400, XP000148196 DESAI P H ET AL: "EVALUATION OF FREON MODULES FOR POWER ELECTRONICS DESIGNED FOR A LOCOMOTIVE TRACTION DRIVE"

## Description

La présente invention concerne les procédés de filtrage en circuit fermé des milieux liquides isolants électriques et caloriporteurs chargés en particules solides contenus dans une cuve à électronique de puissance, en général, et porte, plus particulièrement, sur un dispositif de filtrage d'un milieu liquide isolant électrique et caloriporteur et sur un groupe d'électronique de puissance comportant un tel dispositif, cf. par exemple FR-A-1 064 730.

Dans de nombreuses applications de l'électrotechnique les matériels doivent être aussi compacts que possible, soit pour faciliter leur transport, soit pour ne pas encombrer les systèmes dans lesquels ils sont incorporés. C'est, par exemple le cas des équipements électroniques de puissance embarqués sur les trains à grande vitesse.

Dans les matériels électrotechniques, on trouve différents types de composants ou de sous-ensembles, que ce soit des constituants passifs ou des composants à semiconducteur, et on cherche donc à les rapprocher autant que possible les uns des autres, pour réduire l'encombrement. Dans certains cas, le rapprochement des composants est nécessaire pour diminuer la génération de perturbations électromagnétiques, faciliter le blindage et donc limiter les nuisances émises.

En contrepartie, le rapprochement de composants électriques, qui sont soumis à des tensions diverses et qui chauffent, présente différentes difficultés: outre les problèmes purement mécaniques et les problèmes d'assemblage compact qui sont bien connus, deux types de problèmes majeurs apparaissent.

Le refroidissement des composants est d'autant plus difficile à assurer que la compacité est grande: l'énergie thermique à évacuer est générée dans un volume plus petit, et les transferts sont gênés par les passages réduits entre les composants.

Le champ électrique entre les pièces à différents potentiels est inversement proportionnel aux distances. De plus, les petites dimensions conduisent souvent à des formes à courbures plus faibles, donc à des renforcements locaux de champ électrique.

Tous ces facteurs tendent à augmenter les risques de claquage diélectrique, c'est-à-dire de défaillance par amorçage d'un arc électrique.

Une solution de l'état de la technique pour améliorer la tenue diélectrique et donc supprimer le risque de claquage, consiste à immerger les composants dans un bain de liquide isolant électriquement. A titre d'exemple, une telle solution est utilisée dans les transformateurs haute tension, les bobinages étant alors immergés dans un bain d'huile.

Le refroidissement du bain d'huile est assuré par une circulation du liquide en circuit fermé, le liquide passant par un échangeur au moyen duquel la chaleur est transférée vers l'extérieur. Ce mode de refroidissement convient pour des composants qui ne produisent pas un flux thermique trop grand.

Lorsque le matériel comporte des composants qui nécessitent un refroidissement très performant, cette solution est insuffisante. On peut utiliser une autre solution bien connue: l'ébullition en bain, "Pool-boiling". Les composants sont immergés dans un liquide isolant électriquement et qui peut se mettre en ébullition sous l'effet de la chaleur. La vapeur qui est produite se sépare du liquide et est condensée dans une zone périphérique supérieure, d'où la chaleur est évacuée vers l'extérieur. Le liquide issu de la condensation retourne au bain.

La solution à ébullition en bain décrite ci-dessus a un double avantage:
- D'une part le refroidissement est d'une grande efficacité et les distances de passages n'ont pas à être grandes.
- D'autre part, la tenue diélectrique dans un bain de liquide, même en ébullition, est bien meilleure que dans l'air, ce qui permet de compacter les composants. Ceci est d'autant plus avantageux que la tension de fonctionnement est élevée.

Le principe de pool-boiling est, bien entendu, mis en oeuvre selon de nombreuses variantes, fonction des formes des bains, des condenseurs. De plus, les lois de dimensionnement thermique sont bien établies.

Cette solution avec ébullition en bain a été choisie pour certaines applications industrielles.

A titre d'exemple on peut citer les trains à grande vitesse, lesquelles comportent des cuves à électronique de puissance, où le volume disponible est compté et où la densité de puissance installée est élevée.

Dans ces cuves, des composants passifs et actifs sont immergés dans un liquide, traditionnellement de type CFC, actuellement en voie de remplacement par un substitut ayant sensiblement les mêmes propriétés d'isolant électrique et de caloriporteur par ébullition.

Les risques de claquage électrique sont normalement quasi nuls, grâce à l'immersion des composants sous tension dans le bain de liquide, avec un dimensionnement approprié.

Toutefois, un défaut d'isolement électrique est susceptible d'évoluer jusqu'au claquage par arc électrique en raison d'une diminution lente de la qualité diélectrique du liquide. Ce vieillissement se caractérise par une augmentation lente du taux de particules dans le liquide. Ces particules proviennent de très faible dégradations mécaniques, chimiques, électrochimiques de la surface de divers matériaux qui sont immergés dans le bain de liquide isolant. Il est bien connu que la qualité diélectrique d'un liquide isolant dépend du taux de particules qu'il contient. L'élimination de particules jusqu'à obtenir des taux faibles n'est pas un problème simple et peut rendre nécessaire des moyens complexes et coûteux.

Dans le cas de composants de puissance refroidis par ébullition en bain, dont la fiabilité relative à l'isolation électrique se dégrade progressivement du fait que des particules sont libérés lors du vieillissement du matériel, on peut apporter une solution grâce à un piégeage de ces particules.

Dans le cas de cuves à électronique de puissance pour matériel de traction à grande vitesse, les solutions classiques de filtration avec convection forcée sont difficilement acceptables en pratique: les circuits de fluide, les pompes, les filtres sont mal adaptés, coûteux et moins fiable.

Aussi un but du dispositif de filtrage d'un milieu liquide isolant et calorifique de l'invention est-il de piéger les particules en suspension dans le liquide de telle sorte que le taux de particules augmente plus lentement ou même qu'il soit maintenu constant, de façon à augmenter la durée de vie du matériel et même à maintenir constante la fiabilité de l'isolation électrique.

Un autre but du procédé de filtrage d'un milieu liquide isolant de l'invention est de proposer une solution simple, peu coûteuse, peut encombrante et d'une très grande fiabilité, afin de ne pas introduire un nouveau risque de défaillance.

Conformément à l'invention, le dispositif de filtrage comprend au moins un moyen de chauffage immergé dans un milieu liquide et au moins un moyen immergé de filtrage des particules solides perméables au milieu liquide, ledit moyen de filtrage immergé étant localisé dans un courant de convection naturelle, ledit dispositif étant caractérisé en ce qu'il comprend une enceinte, au moins partiellement immergée dans ledit milieu liquide, contenant ledit moyen de chauffage immergé, ladite enceinte étant constitué au moins partiellement par ledit moyen immergé de filtrage des particules solides du milieu liquide et au moins par un orifice de sortie.

Le dispositif de filtrage de l'invention satisfait également à l'une au moins des caractéristiques suivantes:
- ledit orifice de sortie émerge du milieu liquide,
- ledit orifice de sortie est immergé dans ledit milieu liquide,
- ledit orifice de sortie est fermé par un moyen de filtrage des particules solides perméable au milieu liquide ou au gaz.

Conformément à l'invention, le groupe d'électronique de puissance comprend une cuve étanche à l'intérieur de laquelle sont disposés des composants d'électronique de puissance baignant dans un milieu liquide isolant électrique et caloriporteur, se caractérise en ce qu'il comprend au moins un dispositif de filtrage disposé à l'intérieur de la cuve pour capter au moins partiellement des particules solides indésirables contenues dans le milieu liquide.

Conformément à une caractéristique secondaire du groupe d'électronique de puissance, le moyen de chauffage est constitué par un ou plusieurs des composants d'électronique de puissance dudit groupe.

Un avantage du dispositif de filtrage d'un milieu liquide isolant électrique et caloriporteur de l'invention est de ne mettre en oeuvre aucun accessoire électromécanique tel qu'un moteur ou une pompe.

Un autre avantage du dispositif de filtrage d'un milieu liquide isolant électrique et caloriporteur de l'invention est de ne comporter aucun élément tournant, d'être constitué d'un nombre minimum de composants statiques, dont la fiabilité est garantie et dont le coût est très marginal.

En d'autres termes, selon un grand nombre de configurations possibles, la filtration in-situ, par convection naturelle diphasique, apporte une solution simple, peu coûteuse et bien adaptée à la configuration des cuves.

Un autre avantage du dispositif de filtrage d'un milieu liquide isolant électrique et caloriporteur de l'invention est que les deux éléments essentiels peuvent éventuellement être des composants pré-existants dans le bain.

D'autres buts, caractéristiques et avantages de l'invention apparaîtront à la lecture de la description du procédé et du dispositif de filtrage d'un milieu liquide isolant électrique et caloriporteur, description faite en liaison avec les dessins dans lesquels:
- la figure 1 illustre le principe du procédé de filtrage d'un milieu liquide isolant et caloriporteur de l'invention,
- les figures 2 à 12 montrent différents modes de réalisation de dispositifs de filtrage pour la mise en oeuvre du procédé de filtrage d'un milieu liquide isolant et caloriporteur de l'invention.

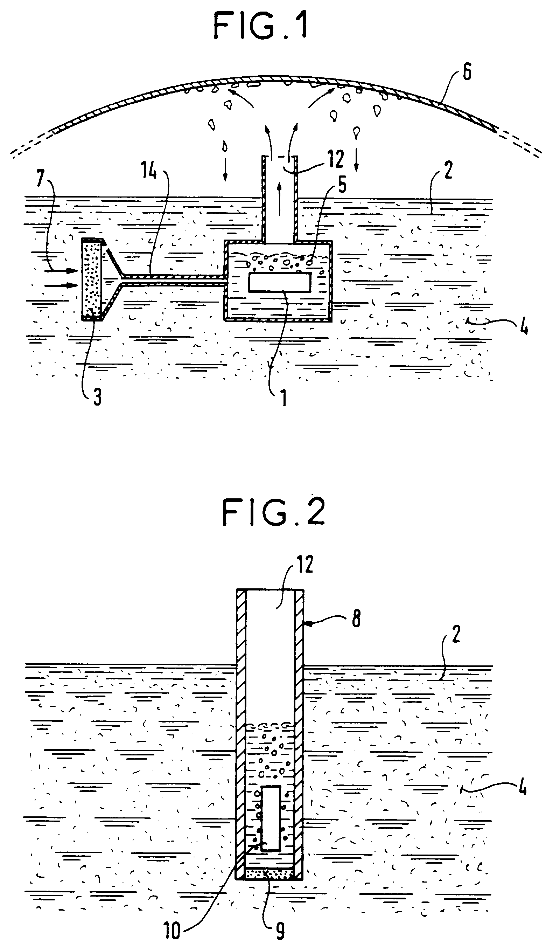

La figure 1 représente un premier mode de réalisation du dispositif de filtrage d'un milieu liquide isolant électrique et caloriporteur illustrant le principe du procédé de filtrage d'un milieu liquide isolant et caloriporteur de l'invention.

Le dispositif de filtrage d'un milieu liquide isolant électrique et caloriporteur selon l'invention comporte un moyen de chauffage 1 du milieu liquide 2 et un moyen de filtrage 3 des particules solides 4 contenu dans le milieu liquide.

L'ensemble moyen de chauffage 1 et moyen de filtrage 3 est immergé dans le milieu liquide, lequel est contenu dans une cuve 6.

Le moyen de chauffage 1 a pour fonction de faire bouillir le liquide avec lequel il est en contact.

Ce moyen de chauffage se compose, par exemple, d'une simple résistance de puissance très faible par rapport à la puissance du matériel à fiabiliser.

Le moyen de filtrage des particules solides du milieu liquide a pour fonction la rétention des particules.

Ce moyen de filtrage des particules solides du milieu liquide se compose, par exemple, d'un ou plusieurs des éléments suivants: chicane, grille, matériau alvéolaire ou poreux, matériau filtrant.

Le moyen de filtrage des particules solides du milieu liquide est de préférence de très petit volume.

La disposition relative entre le moyen de chauffage et le moyen de filtrage des particules solides du milieu liquide est telle que:
- Le milieu liquide en ébullition se transforme en gaz 5. Ce gaz se répand spontanément dans la partie haute de la cuve 6 où il se mèle à la beaucoup plus grande quantité du même gaz mis en oeuvre pour le fonctionnement habituel du matériel. Il se condense et retourne dans le bain sans nécessiter de moyen supplémentaire à ceux pré-existants pour le fonctionnement habituel du matériel.
- Le liquide en ébullition autour de l'élément chauffant disparaît donc progressivement du fait de son passage à l'état gazeux. Il est remplacé par une partie 7 du liquide qui arrive par simple convection naturelle.
- Le liquide qui arrive par simple convection naturelle provient du bain par une ou plusieurs canalisations 14 et traverse le moyen de filtrage des particules solides.

Conformément au procédé et au dispositif de filtrage d'un milieu liquide isolant électrique et caloriporteur de l'invention, un certain flux de liquide du bain contenant un taux de particules donné passe par le moyen de filtrage lequel retient les particules solides.

Ce flux de liquide est transformé en gaz par le moyen de chauffage. Le gaz se condense en haut du bain et le liquide correspondant revient dans le bain exempt de particules solides.

Il suffit que le dimensionnement des moyens de chauffage qui assure ce flux de liquide soit suffisant pour que la quantité de particules piégées dans un laps de temps de fonctionnement donné soit au moins égale à la quantité de nouvelles particules générée par le vieillissement durant un temps correspondant.

La quantité de particules générée étant faible, même en considérant la durée de vie totale du matériel, le dimensionnement du moyen de filtrage des particules solides peut être petit, même avec une large marge de sécurité.

On peut, bien entendu, imaginer une infinité de dispositions relatives entre le moyen de chauffage et le moyen de filtrage des particules solides, ainsi qu'une multitude de formes pour chacun de ces deux moyens et une multitude d'interconnections.

Les figures 2 à 12 montrent différents modes de réalisation de dispositifs de filtrage pour la mise en oeuvre du procédé de filtrage d'un milieu liquide isolant et caloriporteur de l'invention.

De manière générale, dans la description de ces figures 2 à 12, on entend par tube toutes enceintes ou tous moyens à l'intérieur desquels ou à proximité desquels s'effectue l'ébullition du milieu liquide isolant et caloriporteur.

La figure 2 montre une configuration où le moyen de filtrage des particules solides est placé dans un tube 8 vertical.

La partie haute du tube comporte un orifice de sortie 12 du gaz.

Le fond du tube est réalisé en un matériau poreux 9 et constitue le moyen de filtrage des particules solides.

Le moyen de chauffage se compose d'une résistance chauffante 10 disposée dans le tube.

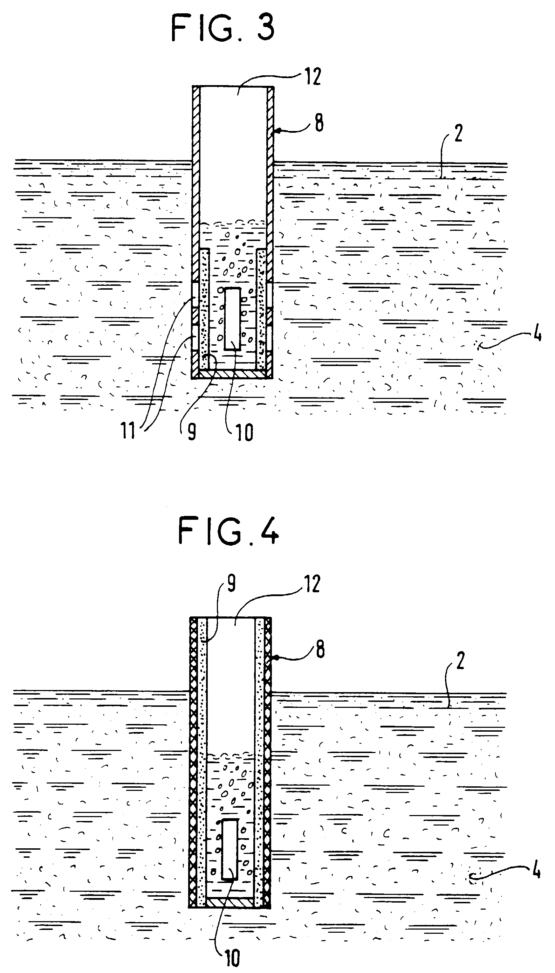

La figure 3 montre une configuration où le moyen de filtrage des particules solides est placé dans un tube 8 vertical comportant des orifices d'entrée 11 du liquide disposés latéralement.

La partie haute du tube comporte un orifice de sortie 12 du gaz.

Le moyen de filtrage des particules solides 4 se compose d'un matériau poreux 9 tapissant partiellement ou totalement l'intérieur du tube perforé, en regard des orifices d'entrée.

Une résistance chauffante 10 est disposée dans le tube.

La figure 4 montre une configuration où le moyen de filtrage des particules solides est placé dans un tube 8 vertical en grillage.

La partie haute du tube comporte un orifice de sortie 12 du gaz.

L'intérieur de ce tube est tapissé d'un matériau poreux 9, ce matériau constituant le moyen de filtrage des particules solides.

Une résistance chauffante 10 est disposée dans le tube.

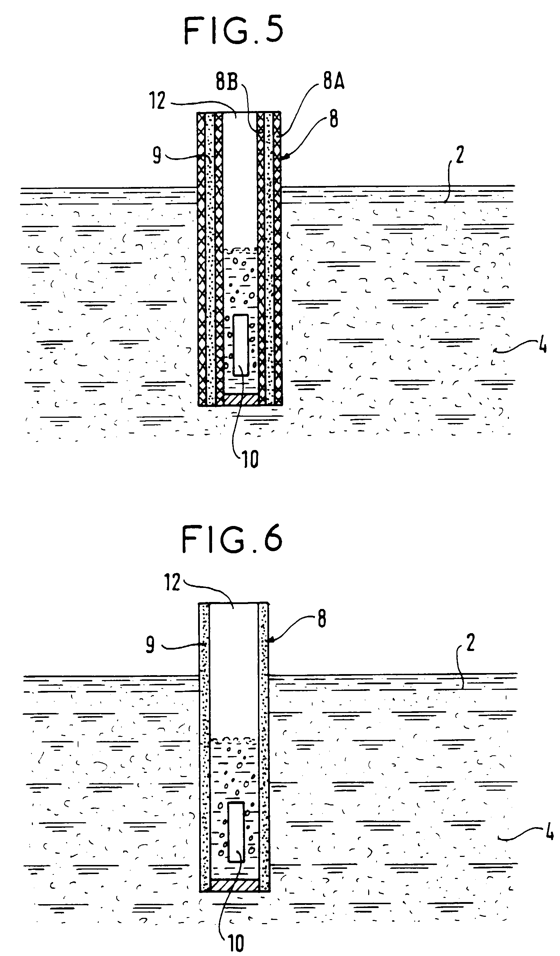

La figure 5 montre une configuration où le moyen de filtrage des particules solides est placé dans un tube 8 vertical en grillage réalisé en deux couches 8A, 8B.

La partie haute du tube comporte un orifice de sortie 12 du gaz.

Le moyen de filtrage des particules solides 4 se compose d'un matériau poreux 9 disposé entre ces deux couches de grillage.

Une résistance chauffante 10 est disposée dans le tube.

La figure 6 montre une configuration où le moyen de filtrage des particules solides 4 est constitué d'un tube 8 vertical en un matériau poreux 9 contenant une résistance chauffante 10.

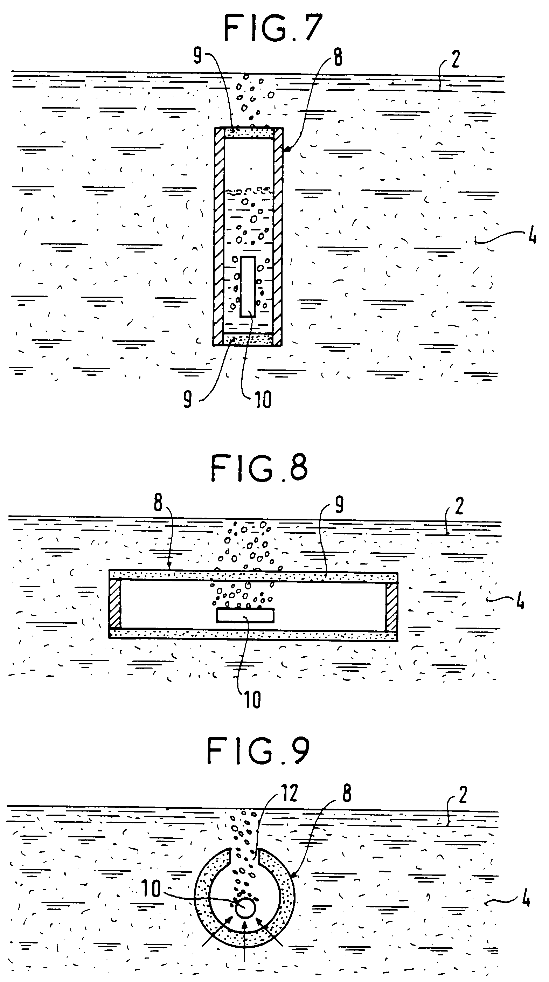

La figure 7 montre une configuration semblable à celle de la figure 2, mais avec deux différences: d'une part le dispositif de filtrage est totalement immergée, d'autre part le moyen de filtrage des particules solides se compose d'un matériau poreux 9 disposé en partie haute et en partie basse du tube 8.

Dans un tel mode de réalisation, le gaz produit sort en traversant le matériau poreux 9 disposé en partie haute du tube.

Tous les modes de réalisation représentés aux figures 2, 3, 4, 5 ou 6 peuvent également être totalement immergée.

La figure 8 montre une dispositif de filtrage disposé horizontalement et totalement immergé. La résistance chauffante 10 est entourée d'un tube en matériau poreux 9. Le matériau poreux filtre le liquide entrant par la partie basse ou par la partie latérale du tube et laisse sortir le gaz en partie haute du tube.

Ce mode de réalisation peut être réalisée selon diverses variantes, à savoir: tube entièrement poreux, tube perforé et revêtement poreux, tube à au moins une couche de grillage.

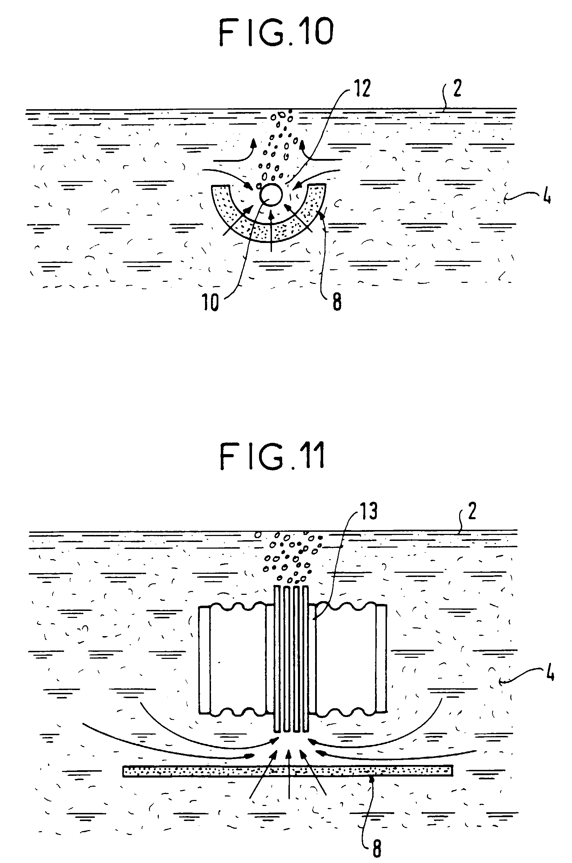

Les figures 9 et 10 montrent des modes de réalisation horizontaux où le tube 8 n'entoure pas complètement la résistance chauffante 10.

La partie supérieure du moyen de filtrage des particules solides situé au-dessus du moyen de chauffage comporte un orifice de sortie 12.

Dans ces modes de réalisation, la totalité du flux de liquide ne passe pas dans le moyen de filtrage des particules solides. Une puissance de chauffe plus forte est donc nécessaire pour que la partie du flux de liquide filtré continue à être suffisante. La puissance de chauffe nécessaire est d'autant plus grande que le passage direct laissé au liquide est plus important par rapport au passage dans le moyen de filtrage.

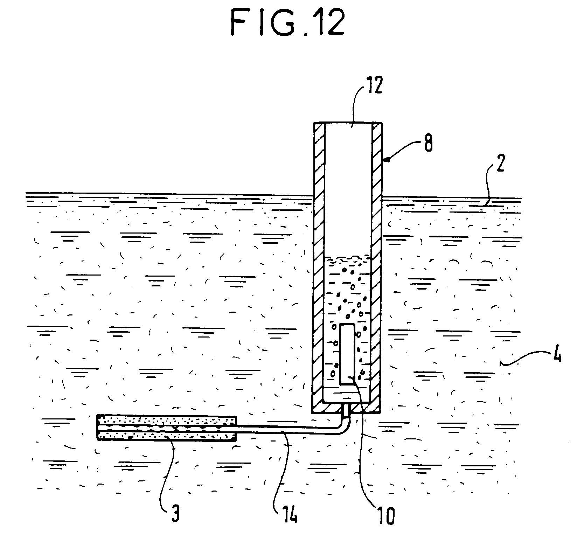

La figure 11 est similaire aux figures 9 et 10. Le passage direct est plus important que le passage représenté aux figures 9 et 11.

Il résulte de ce mode de réalisation que la puissance de chauffe doit être 10 à 100 fois plus élevée que dans les modes de réalisation précédents. Il est alors préférable de ne plus utiliser une résistance chauffante mais d'utiliser l'un ou plusieurs des composants 13 immergés dans le bain qui pré-existait, qu'il faut de toute façon refroidire, et qui évaporent un flux considérable de liquide.

Ce mode de réalisation très simple consiste donc à placer en-dessous des composants de puissance existants dans le bain au moins un moyen de filtrage des particules solides. Ces moyens sont constitués d'une ou de plusieurs couches de matériaux: chicanes, grillages, matériaux poreux. Le flux intense, provoqué par les composants pré-existants refroidis par ébullition de ce flux de liquide en convection naturelle, passe en grande majorité autour du moyen de filtrage des particules solides. Un tel mode de réalisation suffit pourtant à entraîner un flux, faible en proportion, mais néanmoins suffisant, à travers le moyen de filtrage des particules solides.

La figure 12 montre un autre exemple de disposition qui est semblable au mode de réalisation représenté à la figure 2.

Le moyen de filtrage 3 des particules solides 4 est disposé à distance du tube 4 contenant le moyen de chauffage 10. Le moyen de filtrage des particules solides et le moyen de chauffage sont reliés par au moins une canalisation 14.

Les tableaux 1 et 2 ci-dessous donnent, à titre d'exemple, les dimensions principales des dispositifs de filtrage représentés aux figures 2 et 11, respectivement.

**Tableau 1**

| | |
|---|---|
| diamètre du tube: | 20 mm |
| hauteur du tube: | 100 mm |
| diamètre du filtre: | 20 mm |
| épaisseur du filtre: | 2 mm |
| type nominal: | 5 micron |
| diamètre de la résistance: | 6 mm |
| hauteur de la résistance: | 20 mm |
| puissance de la résistance: | 20 w |
| débit théorique du liquide: | 450 cm3/h |
| débit minimum suffisant: | 150 cm3/h |

**Tableau 2**

| | |
|---|---|
| Composant pré-existant: GTO générant 1000W thermique | |
| Distance entre le composant et le moyen filtrant: | 5 mm |
| Constitution du filtre: une couche entre deux grillages | |
| surface: | 100 cm2 |
| épaisseur: | 1 mm |
| débit total du liquide: | 22 dm3/h |
| débit partiel utile: | 0,5 dm3/h |
| débit minimum suffisant: | 0,15 dm3/h |

## Revendications

1. Dispositif de filtrage comprenant au moins un moyen de chauffage (10) immergé dans un milieu liquide (2) et au moins un moyen immergé de filtrage (3, 9) des particules solides (4) perméable audit milieu liquide, ledit moyen de filtrage (3, 9) immergé étant localisé dans le courant de convection naturelle dudit milieu liquide, ledit dispositif étant caractérisé en ce qu'il comprend une enceinte (8), au moins partiellement immergée dans ledit milieu liquide, contenant ledit moyen de chauffage (10) immergé, ladite enceinte (8) étant constituée au moins partiellement par ledit moyen immergé de filtrage (3) des particules solides du milieu liquide et au moins par un orifice de sortie (12).

2. Dispositif selon la revendication 1, dans lequel ledit orifice de sortie (12) émerge dudit milieu liquide.

3. Dispositif selon la revendication 1, dans lequel ledit orifice de sortie (12) est immergée dans ledit milieu liquide.

4. Dispositif selon la revendication 2 ou 3, dans lequel ledit orifice de sortie (12) est fermé par un moyen de filtrage (3) des particules solides perméable au milieu liquide ou au gaz.

5. Groupe d'électronique de puissance comprenant une cuve étanche (6) à l'intérieur de laquelle sont disposés des composants d'électronique de puissance (13) baignant dans un milieu liquide isolant électrique et caloriporteur, caractérisé en ce qu'il comprend au moins un dispositif de filtrage (3) conforme à l'une quelconque des revendications 1 à 4, disposé à l'intérieur de la cuve (8) pour capter au moins partiellement des particules solides (4) indésirables contenues dans le milieu liquide.

6. Groupe selon la revendication 5, dans lequel le moyen de chauffage (10) est constitué par un ou plusieurs des composants d'électronique de puissance (13) dudit groupe.

## Patentansprüche

1. Filtervorrichtung, die zumindest ein Heizmittel (10), das in einem flüssigen Medium (2) eingetaucht ist, und zumindest ein eingetauchtes Mittel zum Filtern (3, 9) von festen Partikeln (4), das für das flüssige Medium durchlässig ist, umfasst, wobei sich das eingetauchte Mittel zum Filtern (3, 9) in dem natürlichen Konvektionsstrom des besagten flüssigen Mediums befindet, **dadurch gekennzeichnet**, dass sie eine Hülle (8) umfasst, die zumindest teilweise in das besagte flüssige Medium eingetaucht ist, die das eingetauchte Heizmittel (10) enthält, wobei die Hülle (8) zumindest teilweise aus dem eingetauchten Mittel zum Filtern (3) von festen Partikeln in dem flüssigen Medium und zumindest aus einer Ausgangsöffnung (12) besteht.

2. Filtervorrichtung nach Anspruch 1, bei der die besagte Ausgangsöffnung (12) aus dem besagten flüssigen Medium auftaucht.

3. Filtervorrichtung nach Anspruch 1, bei dem die besagte Ausgangsöffnung (12) in das besagte flüssige Medium eingetaucht ist.

4. Filtervorrichtung nach Anspruch 2 oder 3, bei dem die besagte Ausgangsöffnung (12) durch ein Mittel zum Filtern (3) von festen Partikeln, das für das flüssige Medium oder Gas durchlässig ist, abgeschlossen ist.

5. Elektronische Leistungsbaugruppe, die einen dichten Behälter umfasst, in dessen Inneren elektronische Leistungsbauteile (13) angeordnet sind, die in einem flüssigen, elektrisch isolierenden und wärmeleitenden Medium baden, dadurch gekennzeichnet, dass sie zumindest eine Filtervorrichtung (3) gemäß einem der Ansprüche 1 bis 4 umfasst, die im Inneren des Behälters (8) angeordnet ist, um zumindest teilweise unerwünschte feste Partikel (4) aufzufangen, die in dem flüssigen Medium enthalten sind.

6. Gruppe nach Anspruch 5, bei der das Heizmittel (10) aus einem oder mehreren elektronischen Leistungsbauteilen (13) dieser Gruppe besteht.

## Claims

1. A filter device comprising at least one heating means (10) immersed in a liquid medium (2) and at least one immersed means (3, 9) for filtering solid particles (4) permeable to said liquid medium, said immersed filter means (3, 9) being located in the natural convection current of said liquid medium, said device being characterised in that it comprises an enclosure (8) at least partially immersed in said liquid medium and containing said immersed heating means (10), said enclosure (8) being at least partially constituted by said immersed means (3) for filtering solid particles in the liquid medium and at least by an outlet orifice (12).

2. A device according to claim 1 wherein said outlet orifice (12) emerges from said liquid medium.

3. A device according to claim 1 wherein said outlet orifice (12) is immersed in said liquid medium.

4. A device according to claim 2 or claim 3 wherein said outlet orifice (12) is closed by means (3) for filtering solid particles permeable to the liquid medium or the gas.

5. Power electronics unit comprising a sealed tank (6) within which are disposed power electronic components (13) immersed in an electrically insulative and thermally conductive liquid medium characterised in that it comprises at least one filter device (3) according to any one of claims 1 to 4 disposed inside the tank (8) to capture at least some of the unwanted solid particles (4) contained in the liquid medium.

6. A unit according to claim 5 wherein the heating means (10) comprise one or more power electronic components (13) of said unit.
